# EUROPEAN PATENT APPLICATION

(11) **EP 4 064 469 A1**
(43) Date of publication of application: **28.09.2022**
(21) Application number: 21305377.0
(22) Date of filing: 25.03.2021
(51) Int. Cl.: H01S 5/026, H01S 5/227, H01S 5/02, H01S 5/20, H01S 5/22, H01S 5/323

(54) **SEMICONDUCTOR DEVICES FOR EMITTING MODULATED LIGHT AND METHODS FOR FABRICATING SUCH DEVICES**

(71) Applicant: Almae Technologies, 91460 Marcoussis (FR)
(72) Inventor: DAI, Xing, 91120 Palaiseau (FR); DEBREGEAS, Hélène, 91470 Boullay-les-Troux (FR)
(74) Representative: Osha Liang

(57) **Abstract**

According to a first aspect, the present disclosure relates to a semiconductor device comprising a semi-insulating substrate (201); a first section (210) configured to emit light; at least a second section (220) configured to modulate light emitted by said first section (210); wherein said first section (210) and said at least second section (220) are monolithically integrated on said semi-insulating substrate (201) and have a common optical waveguide (205'); said first section (210) forms a first vertical PIN junction with a first electrode (212) and a second electrode (214) on said semi-insulating substrate (201); said second section (220) forms a second vertical PIN junction with a first electrode (222) and a second electrode (224) on said semi-insulating substrate (201); an electric resistance between said first electrode (212) of said first section (210) and said first electrode (222) of said second section (220) is superior to about 50 ohms; and an electric resistance between said second electrode (214) of said first section (210) and said second electrode (224) of said second section (220) is superior to about 50 ohms.

## Description

### TECHNICAL FIELD OF THE INVENTION

The present description relates to semiconductor devices configured for emitting modulated light and methods for fabricating such devices.

### BACKGROUND OF THE INVENTION

Optical telecommunications systems and data centers generally comprise semiconductor devices that can generate modulated optical signals in order to transmit data. Such devices generally comprise at least two sections, a laser section that emits light and a modulation section, or modulator, that modulates said light. Each laser section or modulation section is activated by applying a drive signal (for example a voltage or a current) to a pair of electrodes of the section. In such semiconductor devices, each section generally comprises a heterostructure, i.e., an ensemble of semiconductor materials with different bandgaps.

The laser section can for example comprise a distributed feedback (DFB) laser and the modulation section can comprise Electro-absorption modulators (EAMs) which are suitable for very high data rates such as 25 Gb/s, 50 Gb/s or 100 Gb/s.

An EAM relies on the Franz-Keldysh effect or the Quantum-confined Stark effect to produce a change in the amplitude of an optical signal. The EAM is controlled by a time-varying drive signal provided by an external electrical driver to the pair of electrodes of the modulator. The EAM generally requires a drive signal with a peak-to-peak voltage (Vpp) between 1.5V and 2.5V.

Among the available electrical drivers, Complementary Metal-Oxide Semiconductor (CMOS) drivers provide modulation speeds that reach up to 64 Gbaud. However, their drive signal is limited to about 0.8 Vpp, which is too low to directly drive an EAM

For this reason, an electrical amplifier is usually used to amplify the drive signal of the driver so that the drive signal is compatible with the voltage requirements of the modulator. Such an amplifier adds electrical noise, footprint, cost and power consumption. Therefore, there is an interest in modulators having a drive signal compatible with drive signals provided by CMOS drivers, that would eliminate the need for an electrical amplifier.

A first approach is disclosed, for example, in Nakai et al. ("Uncooled Operation of 53-GBd PAM4 (106-Gb/s) EA/DFB Lasers With Extremely Low Drive Voltage With 0.9 Vpp". Journal of Lightwave Technology, 2019, vol. 37, no 7, p. 1658-1662*).* This document discloses a semiconductor device comprising a laser section and a modulator section with an optimized vertical PIN junction compatible with a low drive voltage, down to 0.9 Vpp. A vertical PIN junction is a type of heterostructure comprising a stack of at least three layers of semiconductor materials with different doping superposed on a substrate defining a substrate plane. Said three layers generally comprise a P-doped layer, an undoped active layer and an N-doped layer.

In said semiconductor device of the prior art, the modulator and the laser section are monolithically integrated on the same substrate and share an electrode. In order to prevent electrical cross-talk between the two sections, i.e. to prevent that the drive signal of a section affects the other section, the shared electrode is electrically connected to the ground while the drive signal of each section is fed via the remaining unused electrode in the section. This configuration is referred to as a single-ended drive configuration and can for example prevent the time-varying drive signal of the modulator from disturbing the laser section, which is particularly advantageous in the case that a constant drive is required for the laser section. In such semiconductor device of the prior art, a low drive signal is achieved through a tradeoff between parameters. In particular, such a low drive signal is obtained by imposing a modulator design with very steep extinction at the cost of a lower extinction ratio, and higher insertion losses.

In Adachi et al. ("53-Gbaud PAM4 Differential Drive of a Conventional EA/DFB toward Driver-amplifier-less Optical Transceivers. " Optical Fiber Communications Conference and Exhibition OFC p. 1-3, 2019*),* a chip carrier for driving, in a differential drive configuration, a semiconductor device with a shared electrode between the two sections is proposed. In such a configuration, the required drive signal of the modulation section is reduced by splitting the drive signal evenly among the two electrodes of the section instead of connecting the shared electrode to ground and using only a single remaining electrode of the section.

In Adachi et al., a bypass capacitor connected in parallel to the laser section is used to prevent the signal driving the modulation section from disturbing the laser section (cross talk). Nevertheless, the above solution implies bulky components that increase significantly the dimensions of the semiconductor device and is therefore hardly compatible with integration. Further, the solution is not scalable to a system comprising a plurality of modulation sections, which limits the benefit of the technology.

Another approach disclosed in Hasebe et al. ("Push-pull driven electro-absorption modulator integrated with DFB laser using selectively doped lateral pin diode structure. " in : International Semiconductor Laser Conference. IEEE, 2014. p. 54-55*)* proposes a semiconductor device comprising a laser and a modulator based on lateral PIN junctions, i.e., junctions wherein the layers are juxtaposed on the substrate plane. The lateral PIN junctions make it possible to have the electrodes of the laser section electrically insulated from the electrodes of the modulation section. Therefore, the semiconductor device can be directly used in a differential drive configuration. However, due to the lateral PIN junction, such semiconductor device requires a drive signal with a high Vpp of 3.5V on each electrode (leading to 7Vpp on the modulator PIN junction) that is not compatible with available electrical drivers.

There is thus a need for a semiconductor device comprising a modulator with a vertical PIN junction and that can be directly driven in a differential drive configuration without the need for additional electrical components.

### SUMMARY

In what follows, the term "comprise" is synonym of (means the same as) "include" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a semiconductor device comprising:
a semi-insulating substrate;
a first section configured to emit light;
at least a second section configured to modulate light emitted by said first section;
wherein:
   said first section and said at least second section are monolithically integrated on said semi-insulating substrate and have a common optical waveguide configured to guide said light from said first section to said second section;
   said first section comprises a first doped layer, a second doped layer and the optical waveguide that form a first vertical PIN junction on said semi-insulating substrate;
   said first section further comprises a first electrode electrically connected to said first doped layer and a second electrode electrically connected to said second doped layer;
   said second section comprises a first doped layer, a second doped layer and the optical waveguide that form a second vertical PIN junction on said semi-insulating substrate;
   said second section further comprises a first electrode electrically connected to said first doped layer and a second electrode electrically connected to said second doped layer;
   an electric resistance between said first electrode of said first section and said first electrode of said second section is superior to about 50 ohms; and
   an electric resistance between said second electrode of said first section and said second electrode of said second section is superior to about 50 ohms.

In the present description, a semi-insulating substrate is a substrate comprising a resistivity superior to about 1.10⁶ Ω.cm. According to one or further embodiments, the semi-insulating substrate is made of Iron doped InP.

According to one or further embodiments, an electric resistance between said first electrode of said first section and said first electrode of said second section is superior to about 100 ohms, advantageously about 500 ohms.

According to one or further embodiments, an electric resistance between said second electrode of said first section and said second electrode of said second section is superior to about 100 ohms, advantageously about 500 ohms.

By virtue of such original arrangement, the two sections can directly be driven in a differential configuration without any cross-talk between the two sections so that it is possible to use a driving signal with a lower drive signal than the drive signal required in semiconductor devices of the prior art. Consequently, the power consumption of the semiconductor device may be reduced. In particular, due to the combination of vertical PIN junctions and differential configurations, the modulation section and the laser section can be directly driven with a CMOS driver, without electrical amplifier.

Moreover, such original arrangement is directly compatible with a differential drive configuration without requiring additional electronic component (e.g. bypass capacitor) to insulate the laser section from the modulator section. Therefore, the arrangement is compatible with integration in photonic integrated circuits.

According to one of further embodiments, said first doped layer of said first section and said first doped layer of said second section are N-doped layers; and said second doped layer of said first section and said second doped layer of said second section are P-doped layers.

According to one or further embodiments, the P-doped layers are substantially electrically insulated from each other, wherein substantial electrical insulation means that the electric resistance is superior to about 50 ohms. According to one or further embodiments, the P-doped layers are physically separated.

According to one or further embodiments, the N-doped layers are substantially electrically insulated from each other, wherein substantial electrical insulation means that the electric resistance is superior to about 50 ohms. However, in embodiments, they may be a physical connection between the N-doped layers, due for example to the manufacturing process, as long as such connection does not prevent said electrically insulation.

Alternatively, according to other embodiments, said first doped layer of said first section and said first doped layer of said second section are P-doped layers; and said second doped layer of said first section and said second doped layer of said second section are N-doped layers.

According to one or further embodiments, the N-doped layers are substantially electrically insulated from each other, wherein substantial electrical insulation means that the electric resistance is superior to about 50 ohms. According to one or further embodiments, the N-doped layers are physically separated.

According to one or further embodiments, and the P-doped layers are substantially electrically insulated from each other, wherein substantial electrical insulation means that the electric resistance is superior to about 50 ohms. However, the P-doped layers may be physically connected as long as such connection does not prevent said electrically insulation.

According to one or further embodiments, the semiconductor device according to the first aspect further comprises at least a third section, configured to receive light modulated by said second section;
wherein:
said first section, said second section, and said at least third section are monolithically integrated on said substrate and comprise said common optical waveguide;
said third section comprises a first doped layer and a second doped layer and the optical waveguide that form a third vertical PIN junction on said semi-insulating substrate;
said third section further comprises a first electrode and a second electrode electrically connected respectively to said first doped layer and said second doped layer;
an electric resistance between said first electrode of said second section and said first electrode of said third section is superior to about 50 ohms; and
an electric resistance between said second electrode of said second section and said second electrode of said third section is superior to about 50 ohms.

Said third section can be configured to modify properties of the light received from the second section. Said properties of the light can be, for example, the intensity, the amplitude, the phase, the polarization. The third section can be, for example, an amplifier, a phase modulator or an amplitude modulator.

According to a second aspect, the present description relates to a semiconductor sub-assembly comprising:
a semiconductor device according to the first aspect;
an electrical driver configured to apply a first drive signal to said first section and a second drive signal to said second section;
wherein said second drive signal comprises a differential voltage signal or a differential current signal applied to said electrodes of said second section;

According to one or further embodiments, said second drive signal further comprises at least one voltage modulation or at least one current modulation.

In such a sub-assembly, the modulation section of the semiconductor device can be driven in a differential configuration with a drive signal comprising a modulation without requiring an electrical amplifier.

Therefore, the semiconductor sub-assembly does not require an electrical amplifier and its power consumption is reduced compared to semiconductor sub-assemblies that comprise an electrical amplifier.

According to one or further embodiments, said first drive signal comprises a differential voltage or differential current applied to said electrodes of said first section.

It is therefore possible to drive the first section, for example a laser section, in a differential configuration to reduce the consumption of the electrical driver driving the first section.

According to one or further embodiments, said first drive signal further comprises at least one voltage modulation or at least one current modulation.

It is therefore possible to modulate light with both the first and the second section without requiring an electrical amplifier. Modulating light with the combined effect of the first and the second section can be used to optimize the modulation of the light that is emitted from the semiconductor device, for example to increase the power of the modulated light.

According to one or further embodiments, said electrical driver is a CMOS driver.

According to a third aspect, the present description relates to an optical module comprising a semiconductor sub-assembly according to the second aspect of the present description and optical coupling means configured to couple light emitted by said semiconductor device to at least one optical component.

The optical coupling means comprise, for example, at least one of the following optical elements or a combination thereof: optical lenses, optical fibers, optical isolators, waveplates, beam splitters, optical gratings or optical attenuators.

By virtue of the low power consumption of the semiconductor sub-assembly compared to sub-assemblies known in the prior art, the optical module according to the third aspect of the present description is also easier to integrate in large-scale systems such as data centers, without increasing costs.

According to a fourth aspect, the present description relates to a method for fabricating a semiconductor device, comprising:
providing a PIN junction on a semi-insulating substrate, wherein said PIN junction comprises a first doped layer on top of said substrate, an undoped active layer on top of said first doped layer, and a second doped layer on top of said undoped active layer;
etching, at least partially, said second doped layer to define an electrically insulating section between a first section and at least a second section, wherein said second doped layer only remains unetched in said first section and in said second section;
depositing a waveguide mask, preferably in shape of a strip, that covers partially said first section, said at least second section and said electrically insulating section;
etching regions of said first section, said at least second section and said electrically insulating section that are not covered by the waveguide mask, so that:
   said first doped layer and said undoped active layer are removed in regions of the electrically insulating section that are not covered by the waveguide mask;
   said second doped layer and said undoped active layer are removed in regions of said first section and said at least second section that are not covered by the waveguide mask; and
   the remaining of said undoped active layer forms an optical waveguide;
removing said waveguide mask in said electrically insulating section;
providing a semi-insulating epitaxy layer in said electrically insulating section and in regions of said first section and said at least second section that are not covered by the waveguide mask, in order to bury a region of said optical waveguide that is comprised in said electrically insulating section;
removing said waveguide mask to uncover, at least partially, said second doped layer in said first section and said at least second section;
at least partially removing said semi-insulating epitaxy layer in said first section and said at least second section, in areas outside of the waveguide, to uncover said first doped layer of the first section and the at least second section in said areas.

By virtue of the method according to the fourth aspect, the first doped layer of the first section and the first doped layer of the second section are only physically connected through a strip, wherein the strip is thin and narrow enough to confer substantial electrical insulation between the first doped layer of the first section and the first doped layer of the second section.

Moreover, the second doped layer of the first section and the second doped layer of the second section are physically separated from each other or only physically connected through a strip, wherein the strip is thin and narrow enough to confer substantial electrical insulation between the second doped layer of the first section and the second doped layer of the second section.

Therefore, an electric resistance between said first electrode of said first section and said first electrode of said second section is superior to about 50 ohms; and an electric resistance between said second electrode of said first section and said second electrode of said second section is superior to about 50 ohms.

According to one or further embodiments, the method further comprises,
depositing two N-electrodes respectively in contact with said first doped layer of said first section and said first doped layer of said second section; and
depositing two P-electrodes respectively in contact with said second doped layer of said first section and said second doped layer of said second section

The N-electrode and the P-electrode of the first section thus form a pair of electrodes of the first section. The N-electrode and the P-electrode of the second section thus form a pair of electrodes of the second section.

According to one or further embodiments, the N-electrodes and P-electrodes of the first section and the second section can comprise the same material, preferably an electrically conductive material, for example a metal.

By virtue of said electrodes it is possible to electrically connect an external driver to said first doped layers and said second doped layers of respectively said first section and said at least second section.

According to one or further embodiments, the method further comprises, before depositing said electrodes in the second section, depositing a capacitance pad in contact with the second doped layer of said second section, wherein said at least one capacitance pad is configured to decrease an electrical capacitance of the P-electrode of the second section.

According to one or further embodiments, the method further comprises, before depositing said electrodes in the first section, depositing a capacitance pad in contact with the second doped layer of said first section, wherein said at least one capacitance pad is configured to decrease an electrical capacitance of the P-electrode of the first section.

By virtue of the decrease of the capacitance of the electrode of a section, modulation properties of the section of the semiconductor device are improved. In particular a larger optical modulation bandwidth can be ensured.

In particular, it is possible to deposit capacitance pads both in the first and the second section in order to optimize the modulation of light with the combination of the two sections.

According to one or further embodiments, the method comprises, before depositing said waveguide mask, removing at least partially said second doped layer in said first section and/or said second section, in at least one area outside of the waveguide.

By virtue of this embodiment, it is possible to obtain a semiconductor device wherein parts of said semi-insulating epitaxy layer in said first section and/or said second section are in contact with said semi-insulating substrate. This provides a reduction of the electrical capacitance of the electrodes connected to the second doped layer of the first section and/or the second section. Therefore, the deposition of a capacitance pad in said first section and/or said second section may be avoided, and the modulation bandwidth can be increased.

According to one or further embodiments, said semi-insulating substrate comprises Iron-doped Indium Phosphide.

According to one or further embodiments, said semi-insulating epitaxy layer comprises Iron-doped or Ruthenium-doped Indium Phosphide.

According to one or further embodiments, said undoped active layer comprises multi-quantum wells.

According to one or further embodiments, said multi-quantum wells comprise ternary or quaternary compound semiconductor materials.

### BRIEF DESCRIPTION OF DRAWINGS

Other advantages and features of the invention will become apparent on reading the description, illustrated by the following figures which represent:
- FIG. 1 represents a block diagram of a semiconductor sub-assembly according to the present description, according to an embodiment;
- FIG. 2A represents a top view of a semiconductor device according to an embodiment of the present description and FIGS. 2B, 2C, 2D and 2E represent sectional views of the semiconductor device illustrated in FIG. 2A;
- FIGS. 3A, 3B, 3C, 4A, 4B and 4C illustrate steps of a method for fabricating a semiconductor device according to the present description, according to an embodiment;
- FIGS. 5 illustrates a variant step of a method for fabricating a semiconductor device according to the present description, according to an embodiment;
- FIGS. 6 illustrates a sectional view of an exemplary semiconductor device obtained according to a variant fabrication method, according to an embodiment.

### DETAILED DESCRIPTION

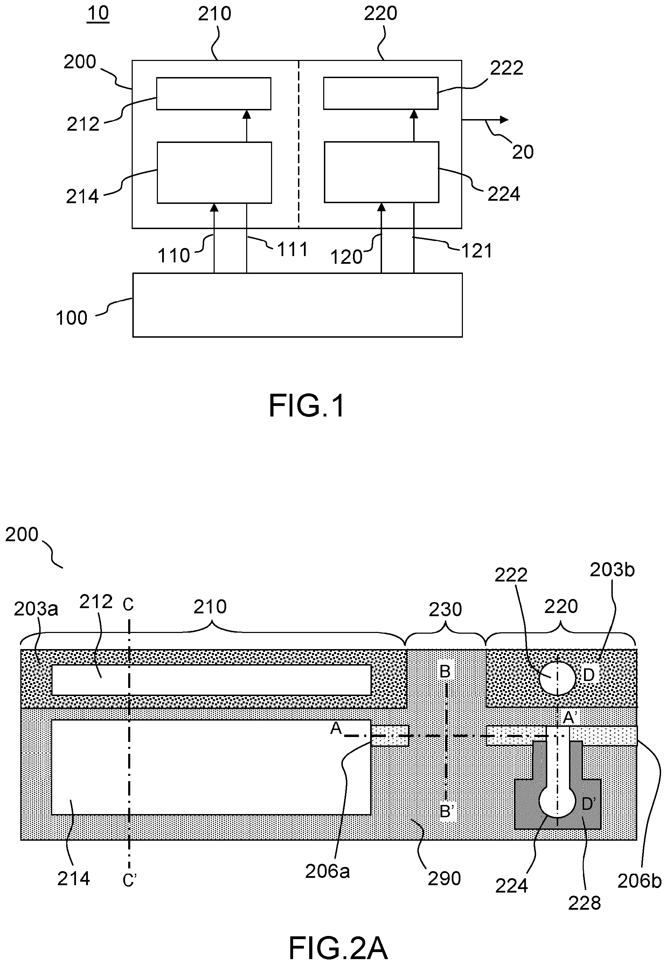

FIG. 1 represents a block diagram of a semiconductor sub-assembly 10 according to an embodiment of the present disclosure.

The semiconductor sub-assembly 10 comprises a semiconductor device 200 and a driver circuit 100. The semiconductor device 200 is configured to emit modulated light 20 when receiving drive signals 110, 111, 120, 121 from the driver circuit 100. The drive signals can comprise, for example, voltage signals or current signals.

In the embodiment shown in FIG.1, the semiconductor device 200 comprises a first section 210 to emit light and a second section 220 to modulate light emitted by said first section 210.

According to one or further embodiments (not shown in the figures), the semiconductor device 200 may comprise three or more sections; in particular it may comprise the first section to emit light, the second section to modulate the light emitted by the first section and a third section configured to receive said modulated light and change at least one property of said modulated light, for example a semiconductor optical amplifier.

According to embodiments of the present disclosure, the first section may be driven in a continuous wave mode with a drive signal that is constant on each electrode.

Alternatively, according to other embodiments of the present disclosure, the first section 210 may be driven in a modulated mode (i.e. with a drive signal that is not constant on at least one electrode). This can be used, for example, to optimize the modulation of the light that is emitted from the semiconductor device 200. In such case, the first section may optionally comprise a capacitance pad (not represented in the figures) in order to increase the optical modulation bandwidth of the first section.

The first section 210 comprises a pair of electrodes 212, 214 and is configured to emit light when a voltage or current signal is applied between the electrodes 212, 214. Similarly, the second section 220 comprises a pair of electrodes 222, 224 and is configured to modulate light emitted by said first section when a voltage or current signal is applied between the electrodes 222, 224.

In the semiconductor device according to the present description, any of the electrodes of a section is substantially electrically insulated from any of the electrodes of another section.

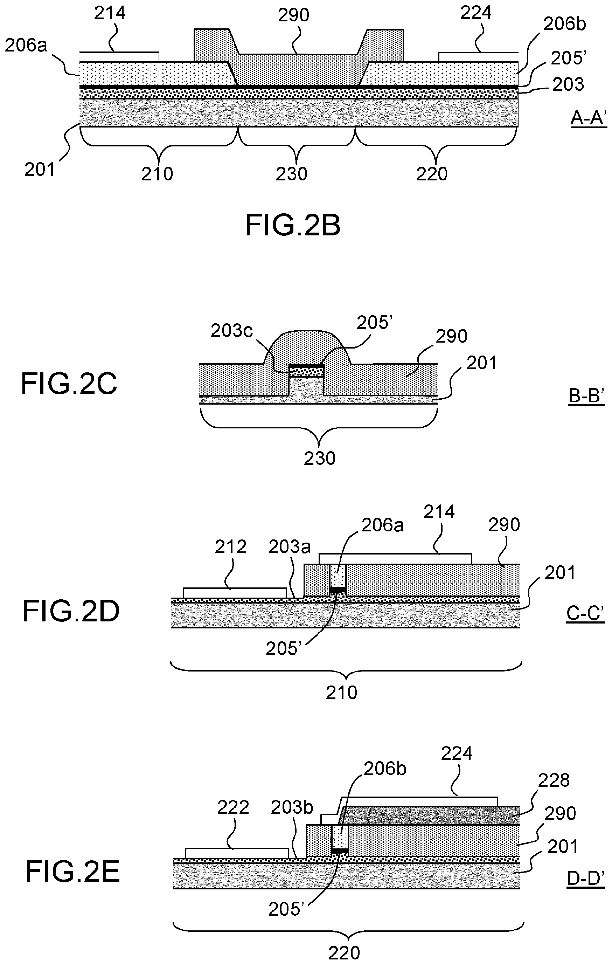

FIGS.2A-2E represent different views of a semiconductor device 200 according to an embodiment of the present disclosure, said semiconductor device 200 comprising a first section 210 configured to emit light and a second section 220 configured to modulate light emitted by the first section 210. In the example shown in FIG. 2A-2E, the first section and the second section are separated by an electrically insulating section 230 configured to insulate the first section 210 from the second section 220.

More specifically, FIG. 2A represents a top view of the semiconductor device 200 and FIGS.2B-2E represent the semiconductor device shown in FIG. 2A under different sectional views (A-A', B-B', C-C', D-D'). Sectional view A-A' illustrates the semiconductor device along the direction of light propagation. Sectional view B-B' illustrates the semiconductor device between the first section and the second section, in the electrically insulating section 230. Sectional views C-C' and D-D' illustrate the first section 210 and the second section 220, respectively.

The first section 210 (also referred to as laser section in the present description) can form a laser of different types, for example: a Distributed Feedback Laser (DFB), a Distributed Bragg Reflector (DBR), a Sampled Grating Distributed Bragg Reflector (SG-DBR), and a Digital Supermode Distributed Bragg Reflector (DS-DBR).

The second section 220 (also referred to as modulation section in the present description) can form a modulator of different types, for example an Electro-absorption modulator (EAM).

In the embodiment shown in FIGS. 2A-2E, the first section 210 and the second section 220 comprise two vertical PIN junctions monolithically integrated on a common substrate 201 and sharing a common optical waveguide 205'. The substrate 201 and the optical waveguide 205' are not visible on FIG. 2A (because it is arranged within the PIN junction) but are visible on FIGS. 2B-2E. The semiconductor device is partially covered with a semi-insulating epitaxy layer 290.

According to embodiments of the present disclosure, the integration of the two vertical PIN junctions can be made using, for example, butt-joint technology, selective area growth, quantum well intermixing, or quantum well offset technique.

According to embodiments of the present disclosure, the two sections of the vertical PIN junction can also be two areas from a single vertical PIN junction.

In the embodiment of the semiconductor device 200 shown in FIG. 2A-2E, the first section 210 is a vertical PIN junction that comprises the optical waveguide 205', an N-doped layer 203a in contact with the substrate 201, and a P-doped layer 206a.

In the embodiment of the semiconductor device 200 shown in FIG. 2A-2E, the first section 210 further comprises a P-electrode 214 and a N-electrode 212 that are configured to provide electrical connection to the P-doped layer 206a and the N-doped layer 203a, respectively. The electrodes 214, 212, also referred to as electrodes of the first section, are conductive layers that can be used to drive the laser section 210 with an external drive signal so that it emits light.

In an embodiment of the semiconductor device shown in FIG. 2A-2E, the second section 220 is a vertical PIN junction that comprises the optical waveguide 205', an N-doped layer 203b in contact with the substrate 201, and a P-doped layer 206b.

In the embodiment of the semiconductor device shown in FIG. 2A-2E, the second section 220 further comprises a P-electrode 224 and a N-electrode 222 that are configured to provide electrical connection to the P-doped layer 206b and the N-doped layer 203b, respectively. The electrodes 224, 222, also referred to as electrodes of the second section, are conductive layers can be used to drive the modulation section 220 with an external drive signal so that the modulation section 220 modulates the light emitted by the laser section 210.

In the embodiment of the semiconductor device 200 shown in FIG. 2A-2E, the electrically insulating section 230 comprises the optical waveguide 205' and a N-doped layer 203c in contact with the substrate 201.

The second section 220 may optionally comprise a capacitance pad 228 arranged between the P-electrode 224 and the semi-insulating epitaxy layer 290. The capacitance pad 228 can reduce the capacitance of the P-electrode, thereby providing a larger optical modulation bandwidth for the second section.

The N-doped layers 203a, 203b and P-doped layers 206a, 206b may comprise N-doped, respectively P-doped, semiconductor materials, for example: Indium Phosphide (doped with Beryllium or Zinc for the P-doped layers and Silicon or Tin for the N-doped layers); Gallium Arsenide (doped with Carbon, Beryllium or Zinc for the P-doped layers, and Silicon or Tellurium for N-doped layers); or Gallium Antimonide (doped with Silicon for the P-doped layers and Tellurium for the N-doped layers).

According to embodiments of the present disclosure, the electrically insulating section 230 and parts of the first and second section 210, 220 are covered with a semi-insulating epitaxy layer 290. The semi-insulating epitaxy layer 290 comprises an electrically insulating material that has a refractive index that is close to the refractive index of the P-doped layers 206a, 206b, i.e. the difference between the refractive indices is for example less than about 0.01, for example Iron- or Ruthenium-doped Indium Phosphide. The semi-insulating epitaxy layer 290 therefore provides electrical insulation between the first section 210 and the second section 220 and ensures index matching of the surroundings of the optical waveguides 205' in the electrically insulating section 230 with the surroundings of the optical waveguides 205' in the first and second section 210, 220 in order to prevent optical losses when light propagates in the optical waveguide from the first section to the second section.

In the embodiment of the semiconductor device shown in FIG. 2A-2E, the N-doped layer 203a of the first section 210 and the N-doped layer 203b of the second section 220 are only physically connected through the N-doped layer strip 203c (referred to as "strip") of the electrically insulating section 230. In particular the N-doped layers 203a, 203b and the strip 203c are parts of the same N-doped layer 203.

The strip is thin enough and narrow enough to provide substantial electrical insulation between the N-doped layers 203a, 203b. Therefore, the N-electrodes 212, 222 are substantially insulated from each other. In practice, the strip is considered thin enough when the thickness of the strip is less than about 2 micrometers. In practice, the strip is considered narrow enough when the width of the strip is less than about 2 micrometers.

In the embodiments shown in FIGS. 2B-2E, the P-doped layer 206a of the first section 210 is separated and substantially insulated from the P-doped layer 206b of the second section 220. Therefore, the P-electrodes 214, 224 are substantially insulated from each other.

In some cases, it is possible that the P-doped layers (206a, 206b) are not separated but are physically connected through a strip, wherein the strip is thin and narrow enough to confer substantial insulation between the P-doper layer 206a of the first section 210 and the P-doped layer 206b of the second section 220.

In the semiconductor device according to the present description, the pair of electrodes (212, 214) of the first section are substantially electrically insulated from the pair of electrodes (222, 224) of the second section, it is therefore possible to drive independently the first and second sections.

In particular, the applicant has shown experimentally that an inter-electrode electrical resistance between any of the electrodes of the first section and any of the electrodes of the second section superior to about 2000 ohms ensures that there is no electrical cross-talk between the first section 210 and the second section 220, *i.e.* that the signal driving the second section 220 is not affecting the first section 210, and *vice-versa.*

However, the applicant showed that the N-doped layer should not be too thin in order to avoid an excess of access resistance. The access resistance comes from the fact that the electrical contact to the N-doped layers 203a, 203b at the bottom of the junction is not made directly below the optical waveguide 205' but on a side (see FIG. 2D-2E), consequently there is a resistive contribution of the N-doped layers 203a, 203b between the waveguide 205' and the location of the electrodes 212, 222.

The applicant has shown that an optimal vertical thickness of the N-doped layer 203 can be chosen as a tradeoff between a low enough access resistance and a high enough electrical insulation between the N-doped layers 203a, 203b of the first and second sections 210, 220.

As a non-limiting example, the resistivity of an N-doped layer 203 made of N-doped InP material with a doping level of about 10¹⁸ cm⁻³ is about 0.002 Ω.cm; the insulating section 230 is about 75 micrometers long, the optical waveguide 205' (and the layer strip 203c) is about 1.5 micrometers wide and the N-doped layer 203 is about 1 micrometer thick. Therefore, a value of the inter-electrode resistance between the N-doped layers 203a, 203b (i.e. the resistance of the N-doped layer strip 203c) may be about 1 kQ, which is considered high enough to substantially insulate the N-doped layers 203a, 203b.

In general, the resistivity of an N-doped layer 203 made of N-doped InP material can range between about 0.001 Ω.cm and about 0.01 Ω.cm. The insulating section 230 may have a length between 25 and 100µm. The waveguide can have a width ranging between 1 and 2.5 micrometers. The N-doped layer can have a thickness ranging between 0.5 and 3 micrometers.

According to the embodiments of the present disclosure shown in FIGS. 2A-2E, the PIN junctions are arranged so that the N-doped layers 203a, 203b face the substrate 201 and the P-doped layers 206a, 206b face a side of the semiconductor device 200 that is opposite to the substrate 201. This arrangement is referred to as "normal arrangement" in the present description.

Other embodiments of the semiconductor device 200 according to the present description may comprise vertical PIN junctions that are arranged in an opposite manner, with P-doped layers 206a, 206b facing the substrate 201 and N-doped layers 203a, 203b facing a side of the semiconductor device that is opposite to the substrate 201. This alternative arrangement is referred to as "reverse arrangement" in the present description. For example, in the reverse arrangement, the N-doped layers of the first and second section may be physically separated, and the P-doped layers of the first section and the second section may be connected through a thin P-doped layer strip. In the reverse arrangement the electrodes of the first section are also insulated from the electrodes of the second section.

Any of the two arrangements can be chosen without changing the general purpose and technical effects of the invention. Each arrangement may have particular advantages depending, for example, on the materials used to make the doped layers.

As an example, P-doped InP has a higher resistivity than N-doped InP so that in the reverse arrangement the inter-electrode resistance between the doped layers close to the substrate 201 may be increased compared to the normal arrangement. However, the access resistance will be in this case much higher than in the normal arrangement. The normal arrangement may be generally preferred in order to reduce the access resistance.

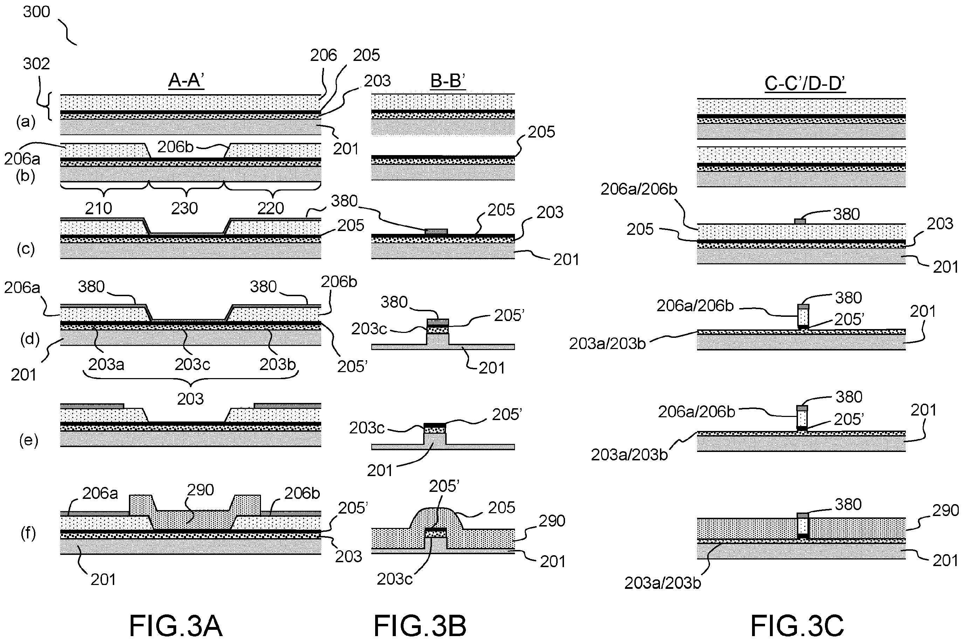

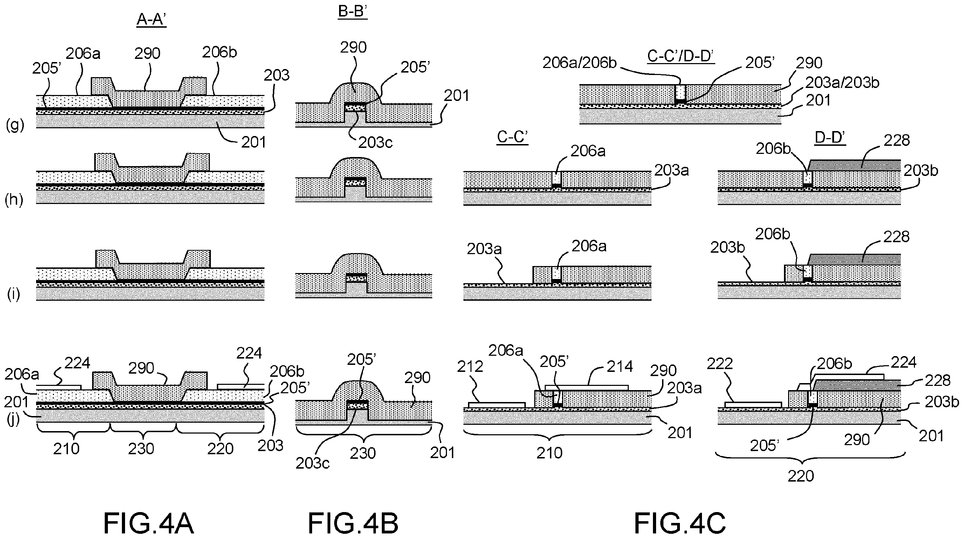

FIGS. 3A-3C and FIGS. 4A-4C illustrate a fabrication method 300 for manufacturing the semiconductor device 200, according to an embodiment of the present description. In particular, FIGS. 3A-3C and FIGS. 4A-4C illustrate different steps (a) to (j) of a fabrication method of a semiconductor device according to an embodiment of the present description under several sectional views (A-A', B-B', C-C', D-D'). Sectional view A-A' illustrates the semiconductor device along the direction of light propagation. Sectional view B-B' illustrates the electrically insulating section 230. Sectional views C-C' and D-D' illustrate the first section 210 and the second section 220, respectively.

In step (a), a PIN junction 302 is provided on top of the semi-insulating substrate 201. According to the embodiment shown in FIGS. 3A-3C and FIGS. 4A-4C, the PIN junction is a vertical PIN junction 302 comprising a stack of three layers comprising an N-doped layer 203, an undoped active layer 205, and a P-doped layer 206.

In the embodiment shown in FIGS. 3A-3C and FIGS. 4A-4C, the N-doped layer 203 is facing the substrate 201 and the P-doped layer 206 is facing a side opposite to the substrate. According to one or further embodiments, the arrangement is reversed and the P-doped layer 203 is facing the substrate 201 while the N-doped layer 206 is facing a side opposite to the substrate.

The vertical PIN junction that is used in step (a) may also comprise a top contact layer (not represented in FIGS. 3A-3C and FIGS. 4A-4C) in contact with the P-doped layer. The top contact layer improves the electrical contact between P-doped layers (206a, 206b) and the P-electrodes (214, 224) deposited in step (j) described later on.

The semi-insulating substrate 201 may comprise materials like Iron-doped Indium Phosphide.

According to one or further embodiments, the vertical PIN junction 302 may be obtained by the juxtaposition of two or more vertical PIN junctions using, for example, the butt-joint technology, selective area growth, quantum well intermixing, or quantum well offset technique.

According to the embodiment shown in FIGS. 3A-3C and FIGS. 4A-4C, the vertical PIN junction 302 is obtained from the juxtaposition of a first and a second PIN junction using butt-joint technology, wherein the first PIN junction is configured to emit light and the second PIN junction is configured to modulate light.

According to one or further embodiments, the composition and structure of each of the three layers in the vertical PIN junction 302 can vary longitudinally, wherein longitudinally is understood as a direction parallel to the light propagation in the semiconductor device.

In particular, the undoped active layer 205 may be structured longitudinally with different structures to provide different optical functions in the sections of the device. The structures can comprise, for example, multi-quantum wells that are optimized differently for light modulation purpose and for light emission purpose. The structures can also comprise an optical grating, for example, in order to form a distributed feedback laser.

According to one or further embodiments, the undoped active layer 205 may comprise a material that is predominantly absorbent at a predetermined wavelength in the laser section 210 and a material that is predominantly transparent at the same predetermined wavelength in the modulation section 220, in order to optimize the power of the light that is emitted by the semiconductor device 200.

In step (b), a first etch procedure is applied to define three sections in the PIN junction, the first section 210 (laser section), the second section (modulation section) 220 and the electrically insulating section 230. The etch procedure may comprise for example, a dry etch, a wet etch or a combination of a wet etch and a dry etch.

In the example shown in FIGS. 3A-3C and FIG. 4A-4C, the first etch procedure (step b) comprises a wet etch with an etchant configured to remove the P-doped layer 206 in the electrically insulating region 230, leaving only parts of P-doped layers 206a, 206b in the first section 210 and the second section 220, respectively. In said example, the wet etch is configured to stop removing material when the etchant reaches the undoped active layer 205.

According to other embodiments (not represented in the figures), the wet etch is configured to stop when the etchant reaches a stop-etch layer preliminarily positioned inside the P-doped layer 206. Therefore, in this case, parts of the P-doped layer 206 remain in the electrically insulating section 230.

According to one or further embodiments, the wet etch is made with a smooth etch angle typically between about 30 degrees and about 40 degrees, preferably about 35 degrees to provide a smooth slope between the electrically insulating section 230 and the first and second section 210, 220, in the direction A-A'.

According to one or further embodiments, the wet etch may be preceded by a dry etch to selectively remove a top contact layer in case the PIN junction comprises such top contact layer.

According to one or further embodiments, the etch procedure may be totally performed by a dry etch and stop above the undoped active layer 205.

In step (c), a Silicon Oxide waveguide mask 380 is deposited selectively on the PIN junction 302 to predefine the geometry of the optical waveguide 205'. As a non-limiting example, the mask may have a rectangular shape with a width of about 1 micrometer to 2.5 micrometers and the mask may have a thickness of about 400 nm to 1000 nm.

Advantageously, the smooth etch angle along the direction A-A' of the optical waveguide 205' that is made in step (b) in case of wet etch facilitates continuity and integrity of the waveguide mask 380 in the electrically insulating section 230.

In step (d), a uniform etch procedure may be applied over the three regions 210, 220, 230 in order to etch the optical waveguide 205' in the undoped active layer 205, according to the geometry predefined by the waveguide mask 380. The uniform etch is configured to remove a uniform thickness of material over the parts of the three sections 210, 220, 230 that are not covered by the waveguide mask 380.

According to embodiments of the present disclosure, the structure obtained after step (c) presents thickness inhomogeneities due to the fact that the P-doped layer 206 is only previously etched in the electrically insulating section 230 but remains unetched in the first and second section 210, 220, so that the thickness of the first and second section 210, 220 is larger than the thickness of the electrically insulating section 230.

As visible in FIG. 3B-3C, step (d), the applicant has shown that the thickness inhomogeneities over the three sections 210, 220, 230 may be used so that the uniform etch procedure simultaneously stops after removing, on the one hand, at least the P-doped layer 206 and the undoped active layer 205 in parts of the first and second sections 210, 220 that are not covered by the waveguide mask 380; and, on the other hand, after removing at least the undoped active layer 205 and the N-doped layer 203 in parts of the electrically insulating section 230 that are not covered by the waveguide mask 380 thus reaching the substrate 201.

According to other embodiments (not represented in the figures) in which the P-doped layer 206 is not totally etched in the electrically insulating section 230 after step (b), the uniform etch procedure may be further configured to remove, in the electrically insulating section 230 and outside of the waveguide mask 380, remains of the P-doped layer 206 (in addition to the undoped active layer 205 and the N-doped layer 203) in order to uncover the semi-insulating InP substrate 201.

The uniform thickness of material that is removed in the uniform etch procedure of step (d) may be controlled by stopping the etching after a predetermined etching time or by monitoring *in-situ* the status of the etch (for example with a laser interferometry-based endpoint detector) and checking that the undoped active layer 205 has been removed from every section 210, 220, 230 that are not covered by the waveguide mask 380.

According to embodiments of the present disclosure, as specifically shown in the example of FIG. 3C (d), the uniform etch is further configured to stop after a predetermined thickness of the N-doped layer 203 is also removed in parts of the first and second sections 210, 220 that are not covered by the waveguide mask 380 in order to ensure that the sidewalls of the optical waveguide 205' are smooth.

In step (e), the waveguide mask 380 is removed in the electrically insulating section 230, for example with a dry etch.

In step (f), a layer of semi-insulating epitaxy layer 290 is regrown selectively on the three sections 210, 220, 230. The applicant has shown that the regrowth can be advantageously made using a Metal-Organic Vapor Phase Epitaxy (MOVPE) technique which is selective on Silicon Oxide. The selectivity of the MOVPE implies that the semi-insulating epitaxy layer 290 only grows in parts of the three sections 210, 220, 230 that are not covered with Silicon Oxide, i.e. the parts that are not covered with parts of the waveguide mask 380 that remain after step (e).

Therefore, the semi-insulating epitaxy layer 290 buries the optical waveguide 205' in the electrically insulating section 230. This technology ensures minimal variations of the effective refractive index of the optical waveguide 205' in the electrically insulating section 230.

As shown in FIGS. 4A-4C, in step (g), the remains of the waveguide mask 280 are removed from the first and second sections 210, 220, for example *via* a selective chemical etch of Silicon Oxide.

After step (g), the fabrication method 300 may differ between the first section 210 and the second section 220. Consequently, after step (g), two different sectional views according to axis C-C' and axis D-D' are shown in FIG. 4C to facilitate the understanding of the process in the two sections 210, 220.

Optionally, in step (h), as represented in FIG.4A-4C, a thick capacitance pad 228 is deposited on the second section 220 to decrease a parasitic capacitance of the P electrode of the second section 220 (see FIG. 4C, section D-D'). The decrease of the capacitance ensures a larger optical bandwidth for the optical modulation capabilities of the second section 220 of the semiconductor device 200.

The parasitic capacitance of the P-electrode may originate from the fact that the P-electrode is arranged on a semi-insulating epitaxy layer 290 that is arranged on a conductive layer (the N-doped layer 203b), thereby creating a PIN junction with capacitance.

In step (i), as shown in FIG. 4C, parts of the semi-insulating epitaxy layer 290 are etched in the first and second sections 210, 220, in areas outside of the waveguide. This uncovers and provides access to the N-doped layers 203a, 203b in order to connect the N-doped layers 203a, 203b to an external driver.

In step (j), N-electrodes 212, 222 are deposited on N-doped layers 203a, 203b of the first and second section 210, 220; and P-electrodes 214, 224 are deposited on P-doped layers 206a and 206b of the first and second sections 210, 220, respectively. The electrodes comprise conductive materials, for example Platinum, Titanium, Gold or combinations thereof.

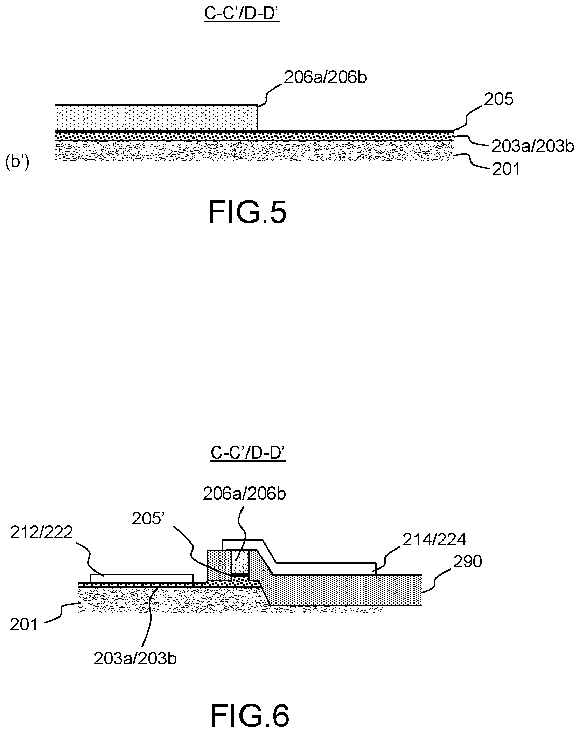

FIG. 5 illustrates a variant of step (b) referred to as (b') in the present description. In variant step (b'), the first etch procedure may be configured to further remove parts of the P-doped layer 206 in the first section 210 and in the second section 220 (in addition to the P-doped layer in the electrically insulating section 230). Precisely, in step (b'), the etch is selectively made in regions of the first section 210 and second section 230 aside from the region where the waveguide mask is deposited in step (c). After step (b'), other steps of the fabrication method are generally performed.

FIG.6 illustrates a view of an exemplary semiconductor device obtained according to a variant fabrication method comprising steps (a, b', c, d, e, f, g, i, j).

According to the embodiment shown in FIG. 6, after performing the variant fabrication method comprising steps (a, b', c, d, e, f, g, i, j), it is possible to have parts of the semi-insulating epitaxy layer 290 of the first section 210 and the second section 220 in contact with the semi-insulating substrate 201. Therefore, the parasitic capacitance of the P-electrode (mainly caused by the presence of parts of the P-doped layers 203a/203b between the semi-insulating substrate 201 and the P-electrodes 214/224) is reduced (or nullified) without requiring for example a capacitance pad. The step (h) can advantageously be avoided in this case.

While the invention has been described with respect to a limited number of embodiments, those skilled in the art, having benefit of this disclosure, will appreciate that other embodiments can be devised which do not depart from the spirit of the invention as disclosed herein. Accordingly, the scope of the invention should be limited only by the attached claims.

## Claims

1. A semiconductor device (200) for emitting modulated light comprising:
a semi-insulating substrate (201);
a first section (210) configured to emit light;
at least a second section (220) configured to modulate light emitted by said first section (210);
wherein:
said first section (210) and said at least second section (220) are monolithically integrated on said semi-insulating substrate (201) and have a common optical waveguide (205') configured to guide said light from said first section (210) to said second section (220);
said first section (210) comprises a first doped layer (203a), a second doped layer (206a) and the optical waveguide (205') that form a first vertical PIN junction on said semi-insulating substrate (201);
said first section (210) further comprises a first electrode (212) electrically connected to said first doped layer (203a) and a second electrode (214) electrically connected to said second doped layer (206a);
said second section (220) comprises a first doped layer (203b), a second doped layer (206b) and the optical waveguide (205') that form a second vertical PIN junction on said semi-insulating substrate (201);
said second section (220) further comprises a first electrode (222) electrically connected to said first doped layer (203b) and a second electrode (224) electrically connected to said second doped layer (206b);
an electric resistance between said first electrode (212) of said first section (210) and said first electrode (222) of said second section (220) is superior to about 50 ohms; and
an electric resistance between said second electrode (214) of said first section (210) and said second electrode (224) of said second section (220) is superior to about 50 ohms.

2. The semiconductor device (200) according to claim 1, wherein:
said first doped layer (203a) of said first section (210) and said first doped layer (203b) of said second section (220) are N-doped layers; and
said second doped layer (206a) of said first section (210) and said second doped layer (206b) of said second section (220) are P-doped layers.

3. The semiconductor device (200) according to any of the preceding claims, further comprising at least a third section, configured to receive the light modulated by said second section (210); wherein:
said first section (210), said second section (220), and said at least third section are monolithically integrated on said substrate (201) and comprise said common optical waveguide (205');
said third section comprises a first doped layer and a second doped layer and the optical waveguide (205') that form a third vertical PIN junction on said semi-insulating substrate (201);
said third section further comprises a first electrode and a second electrode electrically connected respectively to said first doped layer and said second doped layer;
an electric resistance between said first electrode (222) of said second section (220) and said first electrode of said third section is superior to about 50 ohms; and an electric resistance between said second electrode (224) of said second section (220) and said second electrode of said third section is superior to about 50 ohms.

4. A semiconductor sub-assembly (10) comprising:
a semiconductor device (200) according to any of claims 1 to 3;
an electrical driver (100) configured to apply a first drive signal to said first section (210) and a second drive signal to said second section (220);
wherein said second drive signal comprises a differential voltage signal or a differential current signal applied to said electrodes (222, 224) of said second section (220).

5. The semiconductor sub-assembly according to claim 4, wherein said second drive signal further comprises at least one voltage modulation or at least one current modulation.

6. The semiconductor sub-assembly according to any of claims 4 to 5, wherein said first drive signal comprises a differential voltage or a differential current applied to said electrodes (212, 214) of said first section (210).

7. The semiconductor sub-assembly according to any of claims 4 to 6, wherein said first drive signal further comprises at least one voltage modulation or at least one current modulation.

8. The semiconductor sub-assembly according to any of claims 4 to 6, wherein said electrical driver is a CMOS driver.

9. An optical module comprising a semiconductor sub-assembly (10) according to any of claims 4 to 8 and optical coupling means configured to couple light (20) emitted by said semiconductor device (200) to at least one optical component.

10. A method (300) for fabricating a semiconductor device (200) for emitting modulated light, comprising:
providing (a) a PIN junction (302) on a semi-insulating substrate (201), wherein said PIN junction (302) comprises a first doped layer (203) on top of said substrate (201), an undoped active layer (205) on top of said first doped layer (203), and a second doped layer (206) on top of said undoped active layer (205);
etching (b), at least partially, said second doped layer (206) to define an electrically insulating section (230) between a first section (210) and at least a second section (220), wherein said second doped layer (206) only remains unetched in said first section (210) and in said second section (220);
depositing (c) a waveguide mask (380) that covers partially said first section (210), said at least second section (220) and said electrically insulating section (230);
etching (d) regions of said first section (210), said at least second section (220) and said electrically insulating section (230) that are not covered by the waveguide mask (380), so that:
said first doped layer (203) and said undoped active layer (205) are removed in regions of the electrically insulating section (230) that are not covered by the waveguide mask (380);
said second doped layer (206) and said undoped active layer (205) are removed in regions of said first section (210) and said at least second section (220) that are not covered by the waveguide mask (380); and
the remaining of said undoped active layer (205) forms an optical waveguide (205');
removing (e) said waveguide mask (380) in said electrically insulating section (230);
providing (f) a semi-insulating epitaxy layer (290) in said electrically insulating section (230) and in regions of said first section (210) and said at least second section (220) that are not covered by the waveguide mask (380);
removing (g) said waveguide mask (380) to uncover, at least partially, said second doped layer (206a, 206b) in said first section (210) and said at least second section (220);
at least partially removing (i) said semi-insulating epitaxy layer (290) in said first section (210) and said at least second section (220), in areas outside the waveguide, to uncover said first doped layer (203a, 203b) in said first section (210) and said at least second section (220) in said areas.

11. The method as claimed in claim 10, further comprising (j):
depositing two N-electrodes (212, 222) respectively in contact with said first doped layer (203a) of said first section (210) and said first doped layer (203b) of said second section (220); and
depositing two P-electrodes (214, 224) respectively in contact with said second doped layer (206a) of said first section (210) and said second doped layer (206b) of said second section (220).

12. The method as claimed in claim 11, further comprising, depositing (h) a capacitance pad (228) in contact with the second doped layer (203b) of said second section (220), wherein said at least one capacitance pad (228) is configured to decrease an electrical capacitance of the P-electrode of the second section (224).

13. The method as claimed in any of claims 10 to 12, further comprising:
removing (b'), at least partially, said second doped layer (206) in said first section (210) and said second section (220), in at least one area outside of the waveguide.

14. The method as claimed in any of claims 10 to 13, wherein said semi-insulating substrate (201) comprises Iron-doped Indium Phosphide.

15. The method as claimed in any of claims 10 to 14, wherein said semi-insulating epitaxy layer (290) comprises Iron-doped or Ruthenium-doped Indium Phosphide.
